# EUROPÄISCHE PATENTSCHRIFT

(11) **EP 0 370 428 B1**
(45) Veröffentlichungstag und Bekanntmachung des Hinweises auf die Patenterteilung: **04.01.1995**
(21) Anmeldenummer: 89121433.0
(22) Anmeldetag: 20.11.1989
(51) Int. Cl.: H01L 21/28

(54) **Verfahren zur Herstellung von Gate-Elektroden**
Process for manufacturing gate electrodes
Méthode de fabrication d'électrodes de porte

(30) Priorität: 25.11.1988 DE 3839770
(43) Veröffentlichungstag der Anmeldung: 30.05.1990
(73) Patentinhaber: Daimler-Benz Aktiengesellschaft, 70546 Stuttgart (DE)
(72) Erfinder: Geyer, Arthur, Dipl.-Ing. (FH), D-7900 Ulm (DE); Dämbkes, Heinrich, Dr., D-7900 Ulm (DE)
(74) Vertreter: Amersbach, Werner

(56) Entgegenhaltungen:
- IEEE ELECTRON DEVICE LETTERS, Band EDL-7, Nr. 2, Februar 1986, Seiten 69-70,IEEE, New York, US; H.M. MACKSEY: "GaAs power FET's having the gate recess narrower than the gate"
- JOURNAL OF THE ELECTROCHEMICAL SOCIETY, Band 133, Nr. 10, Oktober 1986,Seiten 409-416, Manchester, NH, US; C.E. WEITZEL et al.: "A review of GaAs MESFET gate electrode fabrication technologies"

## Beschreibung

Die Erfindung betrifft ein Verfahren zur Herstellung einer pilzförmigen Gate-Elektrode, insbesondere für Hochfrequenz-Feldeffekttransistoren.

Das Verfahren findet Verwendung bei der Herstellung von Hochfrequenz-Feldeffekttransistoren.

Aus einer Veröffentlichung von P.C. Chao et. al. in IEEE Trans. Electr. Dev., Vol. ED-32. 1042 (1985) ist ein Verfahren zur Herstellung von T-förmigen Gate-Elektroden bekannt, bei dem drei Fotolackschichten zum Aufbau einer entsprechenden Gate-Struktur verwendet werden.

Der Erfindung liegt die Aufgabe zugrunde, ein Verfahren anzugeben, bei dem die Querschnittsdimensionen der Gate-Elektrode variabel einstellbar sind und dadurch die Transistoreigenschaften verbessert werden können.

Das Verfahren hat den Vorteil, daß alle Ätzschritte zur Herstellung der Gate-Struktur auf einer Trockenätzanlage durchgeführt werden können. Das Verfahren ist gut reproduzierbar und es lassen sich in arbeitsökonomischer Weise unterschiedliche Querschnitte der Gate-Elektrode erzeugen. Insbesondere die Erzeugung von Gate-Strukturen mit einer sehr kurzen Gate-Länge, die einen geringen Zuleitungswiderstand der Gate-Elektrode besitzen, sind für die Herstellung von hochfrequenten Feldeffekttransistoren von Vorteil. Dadurch erreicht man eine Erhöhung der maximalen Grenzfrequenz und bessere Verstärkereigenschaften des Transistors. Außerdem wird das Rauschverhalten des Transistors verbessert.

Die Erfindung wird im folgenden anhand eines Ausführungsbeispiels näher erläutert unter Bezugnahme auf schematische Zeichnungen.

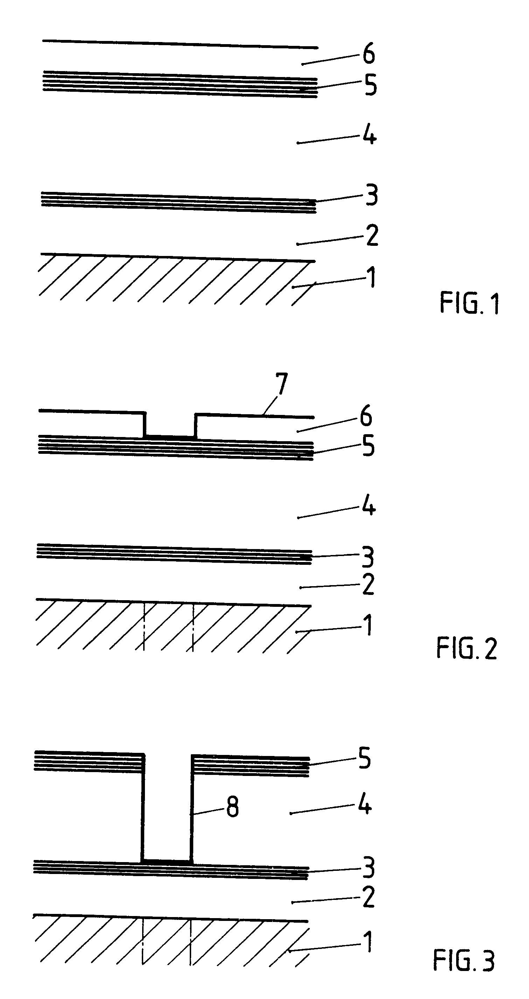

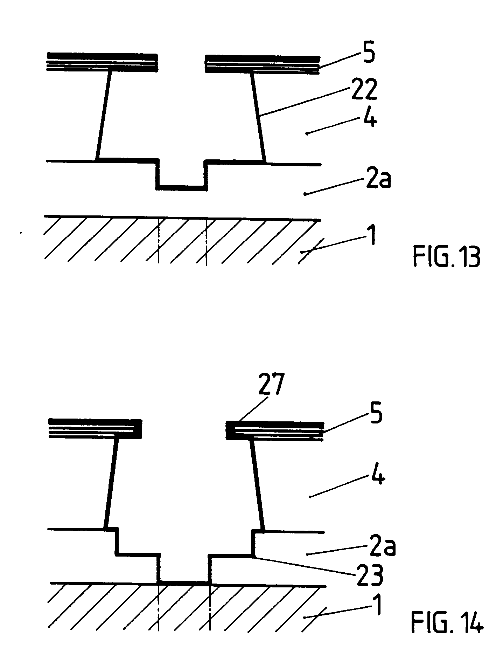

In den Figuren 1 bis 14 ist der Verfahrensablauf einschließlich einiger Verfahrensvarianten zur Herstellung einer im Querschnitt pilzförmigen Gate-Elektrode dargestellt.

Erfindungsgemäß wird vermittels des nachstehend beschriebenen Verfahrens eine im Querschnitt pilzförmige Gate-Elektrode also mit kleiner Standfläche und ausgedehntem Überhang hergestellt.

Die Erfindung benutzt eine 5-Lagen-Technik, deren Aufbau in Fig. 1 dargestellt ist. Auf einem Halbleitersubstrat 1, z.B. GaAs, wird eine etwa 200 bis 500nm dicke erste Polymerschicht 2, z.B. Fotolack AZ4040, aufgebracht. Darüber wird eine dünne Strukturierungsschicht 3, z.B. SiO₂, Si₃N₄ oder Ge von ca. 10 bis 50 und danach eine dicke zweite Polymerschicht 4, z.B. Fotolack AZ 4110 von etwa 500 bis 1100nm abgeschieden. Darüber wird eine weitere Strukturierungsschicht 5, z.B. SiO₂, Si₃N₄ oder Ge mit ca. 30 bis 150nm und zuletzt eine dünne oberste Polymerschicht mit ca. 50 bis 300nm aufgebracht. Diese oberste Schicht 6 besteht entweder aus einem Fotolack für die optische Lithografie, z.B. Fotolack AZ4040, oder aus einem elektronenempfindlichen Fotolack für elektronenoptische Belichtung, z.B. PMMA, zur Erzielung feinster Strukturen. Die Erfindung benutzt zur Erzeugung der Tiefenprofile Ätzverfahren, z.B. Plasmaätzen. Zur exakten Übertragung der Dimension der Strukturen der obersten Schicht in die erste Polymerschicht müssen die einzelnen Ätzprozesse eine möglichst hohe Selektivität zwischen den Polymerschichten 2, 4, 6 und den Strukturierungsschichten 3, 5 aufweisen.

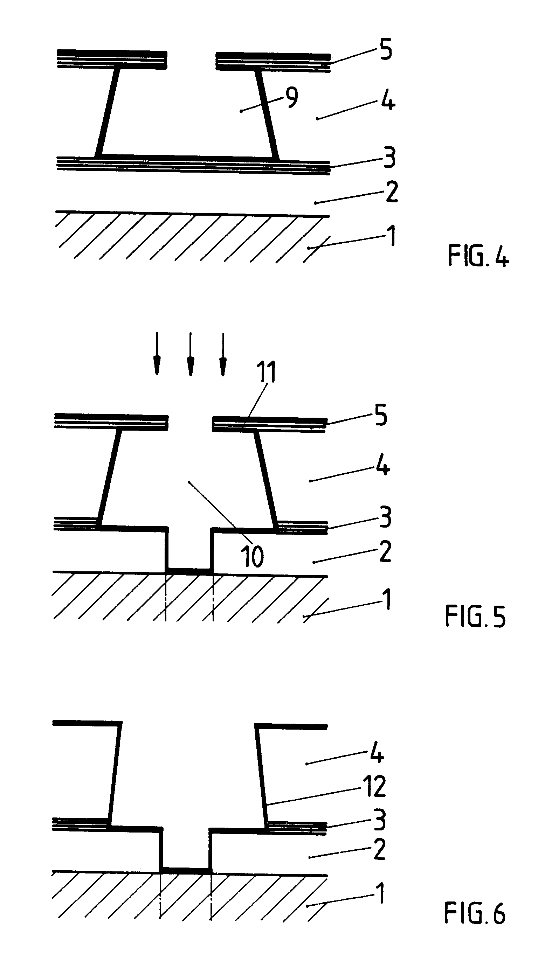

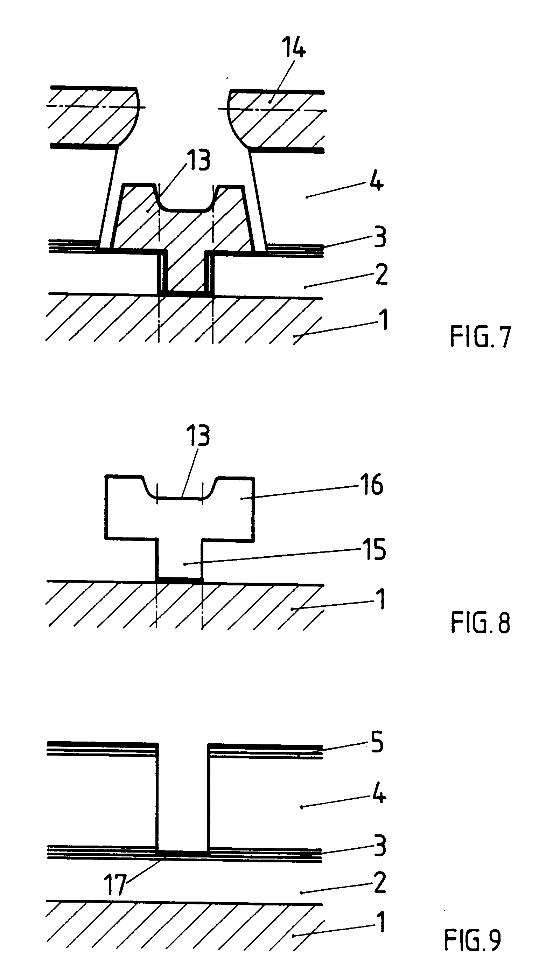

Zunächst wird lithografisch in der obersten Polymerschicht die Sockelstruktur 7 des Gatekontaktes hergestellt (Fig. 2). Danach wird über einen Trockenätzschritt die Sockelstruktur 7 in die obere Strukturierungsschicht 5 eingebracht und anschließend mittels anisotropen RIE (reactive ion etching)-Ätzen diese Struktur exakt bis zur unteren Strukturierungsschicht 3 übertragen. Die obere Polymerschicht 6 wird dabei entfernt und es entsteht der Graben 8 senkrecht zu den Schichten 4, 5 (Fig. 3). Ein folgender isotroper Trockenätzschritt erzeugt eine Unterätzung der oberen Strukturierungsschicht 5 und es entsteht der nach unten erweiterte Graben 9 (Fig. 4) in der zweiten Polymerschicht 4. Anschließend wird ein Fenster in der unteren Strukturierungsschicht 3 geöffnet und ein folgender anisotroper RIE-Ätzprozeß überträgt die Sockelstruktur bis auf die Substratoberfläche. Es entsteht der pilzförmige Graben 10 (Fig. 5). Der Überhang 11 der oberen Strukturierungsschicht 5 dient dabei als Ätzmaske, da bei diesem Ätzschritt hauptsächlich die vertikal auf die Oberfläche gerichteten reaktiven Ionen die Ätzung bewirken. Beim Öffnen des Fensters in der unteren Strukturierungsschicht 3 wird bei gleichem Material von oberer und unterer Strukturierungsschicht die obere Strukturierungsschicht 5 mit abgetragen. Deshalb muß die obere Strukturierungsschicht 5 dicker gewählt werden als die untere Strukturierungsschicht. Nach dem Abätzen der oberen Strukturierungsschicht 5 ist die gewünschte Struktur 12 erzeugt (Fig. 6). Beim anschließenden Aufdampfen des Gate-Metalls belegen sich die schrägen Seitenwände der zweiten Polymerschicht 4 des pilzförmigen Grabens 10 nicht mit Gatemetall (Fig. 7). Ein anschließender lift-off-Prozeß der zweiten Polymerschicht 4 beseitigt gleichzeitig die unerwünschte Metallschicht 14 über der zweiten Polymerschicht 4. Danach werden die untere Strukturierungsschicht 3 und die erste Polymerschicht 2 weggeätzt oder abgelöst und die pilzförmige Gate-Elektrode 13 hat einen Fuß 15 mit der ursprünglichen Sockelstruktur 7 und einen breiten Kopf 16 (Fig. 8). Die Schichtdicken der Strukturierungsschichten sind so dünn gewählt, daß eine genügende Transparenz der Schichten für Justierzwecke bei Elektronenstrahlbelichtung gegeben ist.

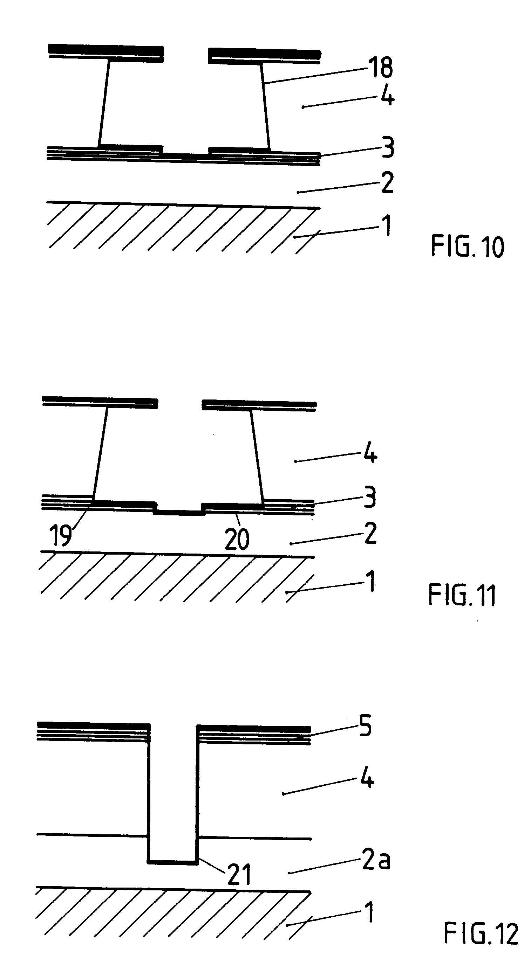

In Anlehnung an das oben angegebene Verfahren werden nachstehend einige Verfahrensvarianten aufgeführt:
a) Durch unterschiedliche Materialien der beiden Strukturierungsschichten 3, 5 und bei genügend selektiven Ätzprozessen können die Schichtdicken der Strukturierungsschichten 3, 5 gleich dünn gewählt werden. Dadurch entfällt bei sehr feinen Gate-Strukturen (z. B. für den Submikrometerbereich) die Notwendigkeit eines strengen anisotropen Ätzens der Strukturierungsschicht 5.
b) Als Ätzmaske beim anisotropen Ätzen der ersten Polymerschicht 2 wird die obere Strukturierungsschicht 5 benutzt. Infolgedessen muß der Überhang 11 genügend mechanische und chemische Stabilität aufweisen, und die obere Strukturierungsschicht 5 muß eine Mindestschichtdicke besitzen. Um diesen Nachteil zu umgehen, wird vor dem isotropen Ätzen der zweiten Polymerschicht 4 ein Fenster 17 in der unteren Strukturierungsschicht 3 bis zur halben Schichtdicke geöffnet (Fig. 9), und danach erst der aufgeweitete Graben 18 erzeugt (Fig. 10). Das anschließende vollständige Öffnen des Fensters in der unteren Strukturierungsschicht 3 erzeugt eine Stufe 19 in dieser Schicht (Fig.11). Es entsteht eine entsprechend der Sockelstruktur 7 dimensionierte Öffnung, die für den nachfolgenden anisotropen Ätzprozeß der ersten Polymerschicht 2 als Ätzfenster dient. Der verbleibende Randstreifen 20 der unteren Strukturierungsschicht 3 auf der ersten Polymerschicht 2 kann sehr dünn sein, da er mechanisch nicht beansprucht wird. Allerdings erfordert diese Verfahrensvariante eine gute Gleichmäßigkeit der Ätzung der Strukturierungsschicht 3.
c) Eine andere Verfahrensvariante benutzt ebenfalls die untere Strukturierungsschicht 3 als Ätzmaske für das anisotrope Ätzen der ersten Polymerschicht 2. Es wird im Gegensatz zur Ausführung nach b) vor dem isotropen Ätzen der zweiten Polymerschicht 4 das Fenster in der unteren Strukturierungsschicht 3 vollkommen geöffnet, danach erst wird das isotrope Ätzen der zweiten Polymerschicht 4 durchgeführt. Dies erfordert jedoch ein selektives Ätzverhalten bei isotropen Ätzbedingungen der zweiten Polymerschicht 4 zur ersten Polymerschicht 2. Im einfachsten Falle ist die erste Polymerschicht 2 ätzresistenter. Anderenfalls muß die Oberfläche der ersten Polymerschicht 2 bei der Schichtenpräparation durch geeignete Oberflächenbehandlung chemisch verändert werden, so daß sich eine hohe Ätzresistenz beim isotropen Ätzen ergibt, oder man erzeugt einen ätzresistenten Film (z.B. im Plasma) auf der Oberfläche der ersten Polymerschicht 2. Beim anschließenden anisotropen Ätzen mit energiereichen reaktiven Ionen muß die erste Polymerschicht 2 ätzbar sein.
d) Weist die zweite Polymerschicht (4) eine wesentlich höhere Ätzrate als die erste Polymerschicht 2 auf, so kann die untere Strukturierungsschicht 3 entfallen (4-Lagen-Aufbau). Als Ätzmaske für das anisotrope Ätzen der ersten Polymerschicht 2 dient hier die obere Strukturierungsschicht.
e) In Anlehnung an die Verfahrensvariante c) wird die erste Polymerschicht 2 durch eine anorganische Schicht (z.B. Isolator, Metall) ersetzt und dadurch ein unterschiedliches Ätzverhalten zur zweiten Polymerschicht 4 erzeugt. Die anorganische Schicht muß eine hohe Selektivität zur unteren Strukturierungsschicht 3 besitzen. Die anorganische Schicht wird durch anisotropes Ätzen geätzt.
   Bei einem derartigen Schichtaufbau kann die untere Zwischenschicht 3 entfallen (4-Lagen-Aufbau). In diesem Fall wird entweder die obere Zwischenschicht 5 als Ätzmaske für die anorganische Schicht 2a verwendet oder es wird eine Stufe 21 in die anorganische Schicht 2a vor dem isotropen Ätzen der Polymerschicht 4 durch einen anisotropen Ätzprozeß eingebracht (Fig. 12). Nach dem isotropen Ätzen der Polymerschicht 4 zur Erzeugung des aufgeweiteten Grabens 22 (Fig. 13) wird durch nachfolgendes anisotropes Ätzen der anorganischen Schicht 2a eine Pilzstruktur mit einem abgestuften Fuß 23 erhalten (Fig.14). Die Stufe des Fußes wird dabei je nach mechanischer und chemischer Stabilität des Überhangs 27 der Strukturierungsschicht 5 unterschiedlich breit ausgebildet.
f) In Anlehnung an die Verfahrensvariante c) wird vor dem Aufweiten der zweiten Polymerschicht 4 ein Fenster in der unteren Strukturierungsschicht 3 geöffnet. Zum Schutze der ersten Polymerschicht 2 wird jedoch vor dem isotropen Ätzen der zweiten Polymerschicht 4 ein dünner Metall- oder Isolatorfilm auf dem Fenster abgeschieden. Im Gegensatz zur Variante nach b) entfällt hier die Erzeugung einer Stufe in der unteren Strukturierungsschicht 3. Die Schichtdicke der unteren Strukturierungsschicht 3 kann somit dünn gewählt werden. Nach dem isotropen Ätzprozeß zur Erzeugung des aufgeweiteten Grabens in der zweiten Polymerschicht 4 wird die Fensterisolierung abgeätzt und das anisotrope Ätzen der ersten unteren Polymerschicht 2 mit der unteren Strukturierungsschicht 3 als Ätzmaske wird anschließend durchgeführt.

## Patentansprüche

1. Verfahren zur Herstellung einer pilzförmigen Gate-Elektrode, insbesondere für Hochfrequenz-Feldeffekttransistoren, wobei
- auf einem Substrat (1) eine Schichtenfolge aus einer ersten Polymerschicht (2), einer unteren Strukturierungsschicht (3), einer zweiten Polymerschicht (4), einer oberen Strukturierungsschicht (5) und einer oberen Polymerschicht (6) abgeschieden wird (FIG. 1),
- die in der oberen Polymerschicht (6) vorgegebene Sockelstruktur der Gate-Elektrode (7) durch einen Trockenätzprozeß in die obere Strukturierungsschicht (5) und anschließend durch einen anisotropen Ätzprozeß auf die erste Strukturierungsschicht (3) übertragen und die obere Polymerschicht (6) entfernt wird,
- durch einen isotropen Ätzprozeß die obere Strukturierungsschicht (5) unterätzt wird und ein bis zur unteren Strukturierungsschicht (3) erweiterter Graben (9) in der zweiten Polymerschicht (4) gebildet wird.
- in der unteren Strukturierungsschicht (3) ein Fenster entsprechend dem Fenster in der oberen Strukturierungsschicht geöffnet wird und durch einem RIE-Ätzprozeß die Sockelstruktur (7) der Gate Elektrode bis auf die Substratoberfläche übertragen wird,
- die obere Strukturierungsschicht (5) und im erweiterten Graben (9) die untere Strukturierungsscicht (3) entfernt wird und eine im Querschnitt pilzförmige Struktur (12) in der Schichtenfolge entsteht,
- durch ganzflächiges Abscheiden einer Metallschicht (14) auf der zweiten Polymerschicht (4) und in der pilzförmigen Struktur (12) eine pilzförmige Gate-Elektrode (13) gebildet wird,
- durch einen lift-off-Prozeß die zweite Polymerschicht (4) und gleichzeitig die darauf aufgebrachte Metallschicht (14) entfernt werden, und
- anschließend die untere Strukturierungsschicht (3) und die erste Polymerschicht (2) weggeätzt werden und lediglich die Gate-Elektrode (13) auf dem Substrat (1) bestehen bleibt.

2. Verfahren nach Anspruch 1, dadurch gekennzeichnet, daß die obere Strukturierungsschicht (5) mit einer dickeren Schichtdicke gewachsen wird als die untere Strukturierungsschicht (3).

3. Verfahren nach Anspruch 1, dadurch gekennzeichnet, daß die obere und untere Strukturierungsschicht (3, 5) aus unterschiedlichem Material aufgebaut werden und gleich dünn gewachsen werden.

4. Verfahren nach einem der Ansprüche 1 bis 3, dadurch gekennzeichnet, daß in die untere Strukturierungsschicht (3) eine Stufe (19), die sich von der Fensteröffnung zur Kante des erweiterten Grabens erstreckt, geätzt wird, die als Ätzfenster für den nachfolgenden Ätzprozeß zur Herstellung des Gate-Elektrodensockels verwendet wird.

5. Verfahren zur Herstellung einer pilzförmigen Gate-Elektrode insbesondere für Hochfrequenz-Feldeffekttransistoren, wobei
- auf einem Substrat (1) eine Schichtenfolge aus einer anorganischen Schicht (2a), einer ersten Strukturierungsschicht (3), einer zweiten Polymerschicht (4) einer oberen Strukturierungsschicht (5) und einer oberen Polymerschicht (6) abgeschieden wird,
- die in der oberen Polymerschicht (6) vorgegebene Sockelstruktur der Gate-Elektrode (7) durch einen Trockenätzprozeß in die obere Strukturierungsschicht (5) und anschließend durch einen anisotropen Ätzprozeß auf die erste Strukturierungsschicht (3) übertragen und die obere Polymerschicht (6) entfernt wird,
- durch einen isotropen Ätzprozeß die obere Strukturierungsschicht (5) unterätzt wird und ein bis zur anorganischen Schicht erweiterter Graben (22) in der zweiten Polymerschicht gebildet wird,
- durch einen RIE-Ätzprozeß die Sockelstruktur (7) der Gate-Elektrode bis auf die Substratoberfläche übertragen wird,
- die obere Strukturierungsschicht (5) entfernt wird und eine im Querschnitt pilzförmige Struktur in der Schichtenfolge entsteht,
- durch ganzflächiges Abscheiden einer Metallschicht (14) auf der zweiten Polymerschicht (4) und in der pilzförmigen Struktur eine pilzförmige Gate-Elektrode gebildet wird,
- durch einen lift-off-Prozeß die zweite Polymerschicht (4) und gleichzeitig die darauf aufgebrachte Metallschicht (14) entfernt werden, und
- anschließend die anorganische Schicht (2a) weggeätzt wird und lediglich die Gate-Elektrode auf dem Substrat (1) bleibt.

6. Verfahren nach einem der vorhergehenden Ansprüche, dadurch gekennzeichnet, daß die Strukturierungsschichten aus SiO₂, Si₃N4 oder Germanium aufgebaut werden.

7. Verfahren nach einem der vorhergehenden Ansprüche, dadurch gekennzeichnet, daß die Polymerschichten aus Fotolack aufgebaut werden.

## Claims

1. Process for manufacturing a mushroom-shaped gate electrode, especially for high-frequency field effect transistors, wherein
- a layer sequence of a first polymer layer (2), a lower structuring layer (3), a second polymer layer (4), an upper structuring layer (5) and an upper polymer layer (6) are deposited on a substrate (1) (FIG.1),
- the base structure, which is preset in the upper polymer layer (6), of the gate electrode (7) is transferred into the upper structuring layer (5) by a dry etching process and subsequently to the first structuring layer (3) by an anisotropic etching process and the upper polymer layer (6) is removed,
- the upper structuring layer (5) is under-etched by an isotropic etching process and a trench (9) widening up to the lower structuring layer (3) is formed in the second polymer layer (4),
- a window corresponding to the window in the upper structuring layer is opened in the lower structuring layer (3) and the base structure (7) of the gate electrode is transferred as far as the substrate surface by an RIE etching process,
- the upper structuring layer (5) and, in the widened trench (9), the lower structuring layer (3) are removed and a structure (12), which is mushroom-shaped in cross-section, arises in the layer sequence,
- a mushroom-shaped gate electrode (13) is formed by whole-area deposition of a metal layer (14) on the second polymer layer (4) and in the mushroom-shaped structure (12),
- the second polymer layer (4) and at the same time the metal layer (14) applied thereon are removed by a lift-off process, and
- subsequently the lower structuring layer (3) and the first polymer layer (2) are etched away and merely the gate electrode (13) remains standing on the substrate (1).

2. Process according to claim 1, characterised thereby that the upper structuring layer (5) is grown with a thicker layer thickness than the lower structuring layer (3).

3. Process according to claim 1, characterised thereby that the upper and lower structuring layer (3, 5) are formed from different material and are grown to be equally thin.

4. Method according to one of claims 1 to 3, characterised thereby that a step (19), which extends from the window opening to the edge of the widened trench (9) and which is used as an etching window for the succeeding etching process for production of the gate electrode base, is etched in the lower structuring layer (3).

5. Process for manufacturing a mushroom-shaped gate electrode, especially for high-frequency field effect transistors, wherein
- a layer sequence of an inorganic layer (2a), a first structuring layer (3), a second polymer layer (4), an upper structuring layer (5) and an upper polymer layer (6) are deposited on a substrate (1),
- the base structure, which is preset in the upper polymer layer (6), of the gate electrode (7) is transferred into the upper structuring layer (5) by a dry etching process and subsequently to the first structuring layer (3) by an anistropic etching process and the upper polymer layer (6) is removed,
- the upper structuring layer (5) is under-etched by an isotropic etching process and a trench (22) widening up to the inorganic layer is formed in the second polymer layer,
- the base structure (7) of the gate electrode is transferred as far as the substrate surface by an RIE etching process,
- the upper structuring layer (5) is removed and a structure, which is mushroom-shaped in cross-section, arises in the layer sequence,
- a mushroom-shaped gate electrode is formed by whole -area deposition of a metal layer (14) on the second polymer layer (4) and in the mushroom-shaped structure,
- the second polymer layer (4) and at the same time the metal layer (14) applied thereon are removed by a lift-off process, and
- subsequently the inorganic layer (2a) is etched away and merely the gate electrode remains standing on the substrate (1).

6. Process according to one of the preceding claims, characterised thereby that the structuring layers are formed from SiO₂, Si₃N4 or germanium.

7. Process according to one of the preceding claims, characterised thereby that the polymer layers are formed from photolacquer.

## Revendications

1. Procédé pour fabriquer une électrode de porte ou de commande en forme de champignon, en particulier une électrode de grille pour transistors à effet de champ pour hautes fréquences, selon lequel
- on dépose sur un substrat (1) une succession de couches constituée d'une première couche de polymère (2), une couche de structuration inférieure (3), une deuxième couche de polymère (4), une couche de structuration supérieure (5) et une couche de polymère supérieure (6) (figure 1),
- on reporte la structure de socle de l'électrode de commande (7), préfixée dans la couche de polymère supérieure (6), au moyen d'un processus de gravure à sec, dans la couche de structuration supérieure (5) et, ensuite, au moyen d'un processus de gravure anisotrope, sur la première couche de structuration (3), et on enlève la couche de polymère supérieure (6),
- par un processus de gravure isotrope, on effectue une gravure sous la couche de structuration supérieure (5) et on forme dans la deuxième couche de polymère (4) un caisson évasé (9) qui s'étend jusqu'à la couche de structuration inférieure (3),
- on ouvre dans la couche de structuration inférieure (3) une fenêtre correspondant à la fenêtre dans la couche de structuration supérieure et on reporte par un processus de gravure du type gravure ionique réactive (RIE) la structure de socle (7) de l'électrode de commande jusque sur la surface du substrat,
- on enlève la couche de structuration supérieure (5) et, dans le caisson évasé (9), la couche de structuration inférieure (3), de sorte qu'il se forme dans la sucession de couches une structure (12) ayant en section droite la forme d'un champignon,
- par le dépôt sur toute la surface d'une couche métallique (14) sur la deuxième couche de polymère (4) et dans la structure (12) en forme de champignon, on crée une électrode de commande ou (13) en forme de champignon,
- par un processus de décollage (lift-off), on enlève la deuxième couche de polymère (4) et, simultanément, la couche métallique (14) appliquée sur elle et
- on supprime ensuite par gravure la couche de structuration inférieure (3) et la première couche de polymère (2) pour ne laisser subsister que l'électrode de commande (13) sur le substrat (1).

2. Procédé selon la revendication 1, caractérisé en ce que l'on fait croître la couche de structuration supérieure (5) avec une plus forte épaisseur que la couche de structuration inférieure (3).

3. Procédé selon la revendication 1, caractérisé en ce que l'on forme les couches de structuration supérieure et inférieure (3, 5) de matériaux différents et on les fait croître de manière qu'elles possèdent la même minceur.

4. Procédé selon une des revendications 1 à 3, caractérisé en ce que l'on forme dans la couche de structuration inférieure (3), par gravure, un gradin (19) qui s'étend depuis l'ouverture de fenêtre jusqu'au bord du caisson évasé (9) et qui est utilisé comme fenêtre de gravure pour le processus consécutif de gravure servant à la fabrication du socle de l'électrode de commande.

5. Procédé pour fabriquer une électrode de porte ou de commande en forme de champignon, en particulier une électrode de grille pour transistors à effet de champ pour hautes fréquences, selon lequel
- on dépose sur un substrat (1) une succession de couches constituée d'une couche inorganique (2a), une première couche de structuration (3), une deuxième couche de polymère (4), une couche de structuration supérieure (5) et une couche de polymère supérieure (6),
- on reporte la structure de socle de l'électrode de commande (7), préfixée dans la couche de polymère supérieure (6), au moyen d'un processus de gravure à sec, dans la couche de structuration supérieure (5) et, ensuite, au moyen d'un processus de gravure anisotrope, sur la première couche de structuration (3), et on enlève la couche de polymère supérieure (6),
- par un processus de gravure isotrope, on effectue une gravure sous la couche de structuration supérieure (5) et on forme dans la deuxième couche de polymère un caisson évasé (22) qui s'étend jusqu'à la couche inorganique,
- par un processus de gravure du type gravure ionique réactive (RIE), on reporte la structure de socle (7) de l'électrode de commande jusque sur la surface du substrat,
- on enlève la couche de structuration supérieure (5), de sorte qu'il se forme dans la succession de couches une structure ayant en section droite la forme d'un champignon,
- par le dépôt sur toute la surface d'une couche métallique (14) sur la deuxième couche de polymère (4) et dans la structure (12) en forme de champignon, on crée une électrode de commande (13) en forme de champignon,
- par un processus de décollage (lift-off), on enlève la deuxième couche de polymère (4) et, simultanément, la couche métallique (14) appliquée sur elle et
- on supprime ensuite par gravure la couche inorganique (2a) pour ne laisser subsister que l'électrode de commande (13) sur le substrat (1).

6. Procédé selon une des revendications précédentes, caractérisé en ce que les couches de structuration sont formées de SiO₂, Si₃N4 ou germanium.

7. Procéde selon une des revendications précédentes, caractérisé en ce que les couches de polymère sont formées de résine photosensible.
